# EUROPEAN PATENT SPECIFICATION

(11) **EP 1 676 300 B1**
(45) Date of publication and mention of the grant of the patent: **01.10.2014**
(21) Application number: 04793905.3
(22) Date of filing: 01.10.2004
(51) Int. Cl.: H01L 21/268, H01L 21/265

(54) **METHOD FOR ANNEALING A SUBSTRATE COMPRISING AN ABSORBER LAYER**
WÄRMEBEHANDLUNGSVERFAHREN EINES SUBSTRATS MIT EINER ABSORBERSCHICHT
PROCEDE DE RECUIT D'UN SUBSTRAT AVEC UNE COUCHE ABSORBANTE

(30) Priority: 03.10.2003 US 679189; 15.01.2004 US 758758
(43) Date of publication of application: 05.07.2006
(73) Proprietor: Applied Materials, Inc., Santa Clara, CA 95054 (US)
(72) Inventor: AUTRYVE, Luc, Van, 91540 Mennecy (FR); BENCHER , Chris, D., San Jose, CA 95131 (US); JENNINGS, Dean, Beverly, MA 01915 (US); LIANG, Haifan, Oakland, CA 94606 (US); MAYUR, Abhilash, J., Salinas, CA 93906 (US); YAM, Mark, Monte Sereno, CA 95030 (US); YEH, Wendy, H., Mountain View, CA 94040 (US); BROUGH, Richard, A., Wingdale, NY 12594 (US)
(74) Representative: Boult Wade Tennant
(86) International application number: PCT/US2004/032151
(87) International publication number: WO 2005/036627

(56) References cited:
- EP-A2- 0 045 593
- US-A1- 2002 160 592
- US-B1- 6 573 030
- VALENTINI L ET AL: "Effect of thermal annealing on the electronic properties of nitrogen doped amorphous carbon/<emph type=1>p</emph>-type crystalline silicon heterojunction diodes" JOURNAL OF VACUUM SCIENCE AND TECHNOLOGY A. VACUUM, SURFACES AND FILMS, AMERICAN INSTITUTE OF PHYSICS, NEW YORK, NY, US, vol. 21, no. 3, May 2003 (2003-05), pages 582-588, XP012006338 ISSN: 0734-2101
- BARRADAS N P ET AL: "Growth and characterisation of amorphous carbon films doped with nitrogen" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 161-163, March 2000 (2000-03), pages 969-974, XP004192364 ISSN: 0168-583X
- M.T. KUO ET AL.: "Field emission studies of low temperature tharmal annealing of nitrogen-doped hydrogenated amorphous carbon (a-C:H:N) films" DIAMOND AND RELATED MATERIALS, vol. 10, no. 3-7, 2001, pages 889-894, XP002314636
- WEILI ZHANG: "Raman analysis of laser annealed nitrogen doped amorphous carbon film" SOLID STATE COMMUNICATIONS, vol. 123, no. 3-4, 2002, pages 97-100, XP002314637
- KULLICK T ET AL: "Diamond-like carbon-gate pH-ISFET", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 44, no. 1-3, 1 October 1997 (1997-10-01), pages 441-445, XP004117156, ISSN: 0925-4005, DOI: 10.1016/S0925-4005(97)00236-0
- Dan Mac Isaac ET AL: "Basic Physics of the Incandescent Lamp (Lightbulb)", THE PHYSICS TEACHER, 1 December 1999 (1999-12-01), pages 520-525, XP055085011, Retrieved from the Internet: URL:http://physicsed.buffalostate.edu/pubs /TPT/TPTDec99Filament.pdf [retrieved on 2013-10-23]

## Description

### BACKGROUND OF THE INVENTION

### Field of the Invention

Embodiments of the present invention generally relate to the fabrication of integrated circuits. More specifically, embodiments of the present invention generally relate to processes for depositing a layer on a substrate and then annealing the substrate.

### Description of the Related Art

Many processes in integrated circuit fabrication require rapid high temperature processing steps for deposition of layers on semiconductor substrates, such as silicon-containing substrates, or annealing of previously deposited layers on semiconductor substrates. For example, after dopant ions, such as boron, phosphorus, or arsenic, are implanted into a semiconductor substrate, the substrate is typically annealed to repair the crystalline structure of the substrate that was disrupted during the doping process and to activate the dopants.

It is typically preferred to heat and cool substrates quickly to minimize the amount of time that a substrate is exposed to high temperatures that can cause unwanted diffusion. Rapid Thermal Processing (RTP) chambers and methods that can raise substrate temperatures at rates on the order of about 200 to 400°C/second have been developed. RTP processes provide an improved rapid heating method compared to the heating provided by batch furnaces, which typically raise substrate temperatures at a rate of about 5-15°C/minute.

While RTP processes can heat and cool a substrate quickly, RTP processes often heat the entire thickness of a substrate. Heating the entire thickness of a semiconductor substrate is often unnecessary and undesirable, as the devices requiring annealing on a semiconductor substrate typically only extend through a top surface layer, such as a few microns of the substrate. Furthermore, heating the entire thickness of the substrate increases the amount of time required for the substrate to cool down, which can increase the time required to process a substrate and thus reduce substrate throughput in a semiconductor processing system. Increasing the amount of time required for the substrate to cool down also limits the amount of time the substrate can be exposed to the elevated temperature required for activation. Shorter heating and cooling times are also desirable because they limit diffusion and minimize device shrinkage.

Uneven heating across the surface of a substrate is another problem that is often experienced with RTP or other conventional substrate heating processes. As today's integrated circuits generally include a plurality of devices spaced at varying densities across a surface of a substrate and having different sizes, shapes, and materials, a substrate surface can have very different thermal absorption properties across different areas of the substrate surface. For example, a first region of a substrate having a lower density of devices thereon typically will be heated faster than a second region of the substrate that has a higher density of devices thereon than the first region. Varying reflectivities across different areas of the substrate surface can also make uniform heating of the substrate surface challenging.

US2002/0160592 discloses a method for forming ultra-shallow junctions using laser annealing, wherein an amorphous carbon layer is used as an energy absorber layer.

H. Voigi et al., 'Diamond-like carbon-gate pH-ISFET Sensors and Actuators B 44 p441-445 (1997) discloses a chemical-resistant ion-selective field-effect transistor array which uses diamond-like carbon films for passivation and as a pH-sensitive layer.

Therefore, there remains a need for a method of uniformly heating a semiconductor substrate across a surface of the substrate during an annealing process.

### SUMMARY OF THE INVENTION

The invention provides a method of processing a substrate according to claim 1. In one embodiment, exposing the substrate to the electromagnetic radiation comprises laser annealing the substrate.

In another aspect, a method of processing a substrate is provided, the method comprising depositing a layer as in claim 1, having a thickness of between about 20 nm (200 Å) and about 2. 5 µm under conditions sufficient to provide the layer with an emissivity of about 0.84 or greater for electromagnetic radiation having a wavelength of between about 600 nm and about 1000 nm, and then laser annealing the substrate.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a cross-sectional diagram of an exemplary chemical vapor deposition reactor configured for use according to embodiments described herein.
Figure 2 is a diagram of a side view of a laser annealing apparatus for use according to embodiments described herein.
Figures 3A-3F are cross sectional views showing an embodiment of a substrate processing sequence.
Figure 4 is a graph showing % absorption of radiation by layers deposited according to embodiments described herein.

### DETAILED DESCRIPTION OF THE PREFERRED EMBODIMENT

Embodiments of the invention provide a method of processing a substrate, comprising depositing an amorphous carbon layer on the substrate to promote uniform heating across a surface of the substrate during annealing of the substrate. In one embodiment, the layer is deposited to a thickness of between about 20 nm (200 Å) and about 2. 5 µm under conditions sufficient to provide the layer with an emissivity of about 0.84 or greater for electromagnetic radiation having a wavelength of between about 600 nm and about 1000 nm, and then laser annealed.

In one example, the layer comprises amorphous carbon and hydrogen. In one example, the layer is an amorphous carbon layer having primarily sp3 bonding and comprising carbon atoms and hydrogen atoms. According to the invention, the layer comprises amorphous carbon and a dopant selected from a group consisting of nitrogen, boron, phosphorus, fluorine, or combinations thereof. In one example, the layer is a doped amorphous carbon layer comprising carbon atoms, hydrogen atoms, and dopant atoms selected from the group consisting of nitrogen, boron, phosphorus, fluorine, and combinations thereof. In one example, the layer is a nitrogen-doped amorphous graphite layer having primarily sp2 bonding. In all examples, preferably, the layer includes no metal or substantially no metal. The layer may be deposited by plasma enhanced chemical vapor deposition (PECVD) of a gas mixture comprising a carbon source. Preferably, the carbon source is a gaseous hydrocarbon, such as a linear hydrocarbon. For example, the carbon source may be propylene (C₃H₆). The gas mixture may be formed from a carbon source that is a liquid precursor or a gaseous precursor. In one example, a liquid precursor is used to improve sidewall and corner coverage of devices or features that may be on the substrate. The gas mixture may further comprise a carrier gas, such as helium (He). Further examples of carbon sources and processing conditions for the deposition of the layer are provided in commonly assigned United States Patent 6,573, 030.
The layer may be deposited to a thickness of between about 10 nm (100 Å) and about 2.0 µm (20,000 Å). Preferably, the layer is deposited to a thickness between about 80 nm (800 Å) and about 150 nm (1500 Å), such as a thickness of about 120 nm (1200 Å). The layer may be deposited in any chamber capable of performing PECVD. In one example, the layer is deposited under high density plasma conditions to enhance the gap filling capability of the layer between devices or features on the substrate. An example of a chamber that may be used is the a DSM APF chamber, available from Applied Materials, Inc., of Santa Clara, CA.

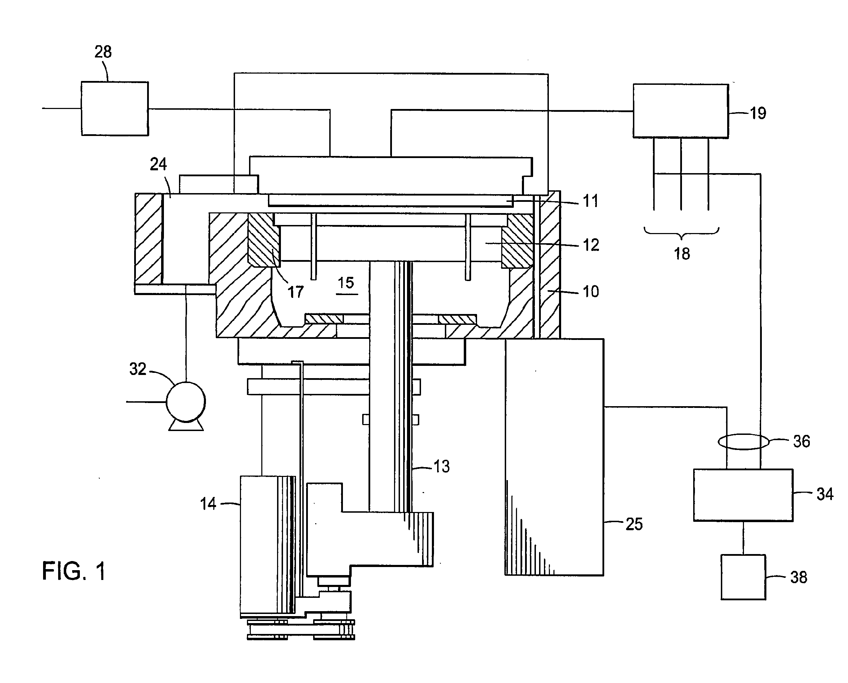

Figure 1 shows an example of a vertical, cross-section view of a parallel plate CVD processing chamber 10. The chamber 10 includes a high vacuum region 15 and a gas distribution manifold 11 having perforated holes for dispersing process gases therethrough to a substrate (not shown). The substrate rests on a substrate support plate or susceptor 12. The susceptor 12 is mounted on a support stem 13 that connects the susceptor 12 to a lift motor 14. The lift motor 14 raises and lowers the susceptor 12 between a processing position and a lower, substrate-loading position so that the susceptor 12 (and the substrate supported on the upper surface of susceptor 12) can be controllably moved between a lower loading/off-loading position and an upper processing position which is closely adjacent to the manifold 11. An insulator 17 surrounds the susceptor 12 and the substrate when in an upper processing position.

Gases introduced to the manifold 11 are uniformly distributed radially across the surface of the substrate. A vacuum pump 32 having a throttle valve controls the exhaust rate of gases from the chamber 10 through a manifold 24. Deposition and carrier gases, if needed, flow through gas lines 18 into a mixing system 19 and then to the manifold 11. Generally, each process gas supply line 18 includes (i) safety shut-off valves (not shown) that can be used to automatically or manually shut off the flow of process gas into the chamber, and (ii) mass flow controllers (not shown) to measure the flow of gas through the gas supply lines 18. When toxic gases are used in the process, several safety shut-off valves are positioned on each gas supply line 18 in conventional configurations.

A controlled plasma is typically formed adjacent the substrate by RF energy applied to the gas distribution manifold 11 using a RF power supply 25. Alternatively, RF power can be provided to the susceptor 12. The RF power to the deposition chamber may be cycled or pulsed. The power density of the plasma is between about 0.0016 W/cm² and about 155 W/cm², which corresponds to a RF power level of about 1.1 W to about 100 kW for a 300 mm substrate.

The RF power supply 25 can supply a single frequency RF power between about 0.01 MHz and 300 MHz, such as about 13.56 MHz. Alternatively, the RF power may be delivered using mixed, simultaneous frequencies to enhance the decomposition of reactive species introduced into the high vacuum region 15. In one aspect, the mixed frequency is a lower frequency of about 12 kHz and a higher frequency of about 13.56 mHz. In another aspect, the lower frequency may range between about 300 Hz to about 1,000 kHz, and the higher frequency may range between about 5 mHz and about 50 mHz.

Typically, any or all of the chamber lining, distribution manifold 11, susceptor 12, and various other reactor hardware is made out of materials such as aluminum or anodized aluminum. An example of such a CVD reactor is described in U.S. Patent No. 5,000,193, emitted "A Thermal CVD/PECVD Reactor and Use for Thernal Chemical Vapor Deposition of Silicon: dioxide and *In situ* Multi-step Planarized Process".

A system controller 34 controls the motor 14, the gas mixing system 19, and the RF power supply 25 which are connected therewith by control lines 36. The system controller 34 controls the activities of the CVD reactor and typically includes a hard disk drive, a floppy disk drive, and a card rack. The card rack contains a single board computer (SBC), analog and digital input/output boards, interface⁻ boards, and stepper motor controller boards. The system controller 34 conforms to the Versa Modular Europeans (VME) standard which defines board, card cage, and connector dimensions and types. The VME standard also defines the bus structure having a 16-bit data bus and 24-bit address bus.

The carbon source may be introduced into the mixing system 19 at a rate of between about 30 sccm and about 3000 sccm, and the carrier gas may be introduced into the chamber at a rate of between about 100 sccm and about 5000 sccm. During deposition, the substrate is maintained at a temperature between about 200°C and about 1500°C, such as a temperature between about 300°C and about 700°C. Preferably, the substrate may be maintained at a temperature between about 350°C and about 550°C. For example, the substrate may be maintained at a temperature of about 550°C. The deposition pressure is typically between about 670 Pa (5 Torr) and about 6700 Pa (50 Torr), such as about 930 Pa (7 Torr), RF power of between about 500 W and about 1500 W may be applied in the chamber at a frequency of about 13.56 MHz.

In one example, the following processing conditions are used: the substrate is maintained at a temperature of between about 350°C and about 550°C; the pressure is between about 800 Pa (6 Torr) and about 1070 Pa (8 Torr); the RF power is applied at between about 2 W/cm² and about 3 W/cm²; C₃H₆ is introduced into the mixing system at between about 3 sccm/cm² and about 5 sccm/cm², and helium is introduced into the mixing system at between about 2 sccm/cm² and about 3 sccm/cm²; and the spacing between the chamber showerhead and the substrate support is between about 6.4 mm (250 mils) and about 7.6 mm (300 mils).

In another embodiment, the layer comprises amorphous carbon and nitrogen. The layer may be deposited by PECVD of a gas mixture comprising the carbon source and a dopant source selected from the group consisting of a nitrogen source, a boron source, a phosphorus source, a fluorine source, and combinations thereof. Preferably, the nitrogen source is nitrogen (N₂). The gas mixture may further comprise a carrier gas, such as helium (He). The carbon source may be introduced into the mixing system 19 at a rate of between about 30 sccm and about 3000 sccm, the dopant source may be introduced into the mixing system 19 at a rate of between about 30 sccm and about 5000 sccm, and the carrier gas may be introduced into the mixing system 19 at a rate of between about 160 sccm and about 5000 sccm. The layer may be deposited to a thickness of between about 80 nm (800 Å) and about 150 nm (1500 Å), such as a thickness of about 115 nm (1150 Å). During deposition, the substrate is maintained at a temperature between about 200°C and about 1500°C. Preferably, the substrate is maintained at a temperature between about 250°C and about 450°C. For example, the substrate may be maintained at a temperature of about 400°C. The deposition pressure is typically between about 670 Pa (5 Torr) and about 6700 Pa (50 Torr), such as about 930 Pa (7 Torr).

In one example, the following processing conditions are used: the substrate is maintained at a temperature between about 250°C and about 450°C; the pressure is between about 800 Pa (6 Torr) and about 1070 Pa (8 Torr); the RF power is applied at between about 3 W/cm²; and about 5 W/cm²; C₃H₆ is introduced into the mixing system at between about 0.8 sccm/cm² and about 1.5 sccm/cm², and N₂ is introduced into the mixing system at between about 8 sccm/cm² and about 12 sccm/cm²; and the spacing between the chamber showerhead and the substrate support is between about 7.6 mm (300 mils) and about 10.2 mm (400 mils).

The layers comprising amorphous carbon and optionally nitrogen are both durable and easily removable from a substrate. The layers typically can withstand processing temperatures of greater than 1200°C and can be removed from a substrate by an oxygen ashing process.

After the layer is deposited on the substrate, the substrate is exposed to electromagnetic radiation have one or more wavelengths between about 600 nm and about 1000 nm under conditions sufficient to heat the layer to a temperature of at least about 300°C. Preferably, the substrate is laser annealed with continuous wave electromagnetic radiation emitted from a laser. As defined herein, "continuous wave electromagnetic radiation"is radiation that is emitted continuously, i. e., not in a burst or pulse. Alternatively, the substrate may be laser annealed with pulses of electromagnetic radiation. In another embodiment, the electromagnetic radiation is provided by a broad range source of electromagnetic radiation, such as a lamp, e. g., a xenon ARC lamp.

According to the invention, the electromagnetic radiation has a wavelength between 808 nm and 810 nm. Preferably, the extinction coefficient of the layer at a wavelength of about 808 nm to about 810 nm is about 0.01 to about 2.0. Typically, the power density of the electromagnetic radiation emitted by the laser is between about 10 kW/cm² and about 200 kW/cm², such as about 90 kW/cm².

During laser annealing, the substrate is scanned with a line of radiation emitted by the laser. The line of electromagnetic radiation may be between about 3 µm and about 500 µm wide, such as about 35 µm wide.

The electromagnetic radiation emitted by the laser or the broad range electromagnetic radiation source is substantially absorbed by the layer. The layer reflects little if any of the electromagnetic radiation emitted by the laser the broad range electromagnetic radiation source. Thus, the layer may be described as both an absorber layer and an anti-reflective coating layer. The layer then transfers the thermal energy created by the absorbed electromagnetic radiation to the substrate on which the layer is deposited, and the substrate is heated and annealed. Preferably, only a top surface layer of the substrate, such as the top 15 µm of the substrate surface that faces the laser is heated and annealed. Thus, in one example, the annealing process is a dynamic surface annealing (DSA) process. In one embodiment, a top surface layer of the substrate is heated to a temperature between about 1100°C and about 1410°C and cooled down to near ambient temperature in a time on the order of 1 millisecond.

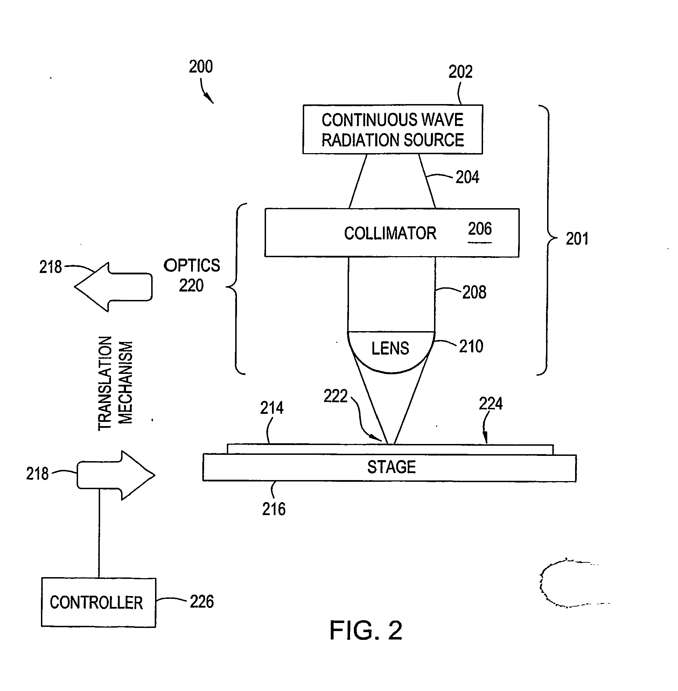

An example of a laser apparatus 200 that may be used with embodiments described herein is shown in Figure 2. The apparatus 200 comprises a continuous wave electromagnetic radiation module 201, a stage 216 configured to receive a substrate 214 thereon, and a translation mechanism 218. The continuous wave electromagnetic radiation module 201 comprises a continuous wave electromagnetic radiation source 202 and focusing optics 220 disposed between the continuous wave electromagnetic radiation source 202 and the stage 216.

In one example, the continuous wave electromagnetic radiation source 202 is capable of emitting radiation continuously for at least 15 seconds. Also, in another example, the continuous wave electromagnetic radiation source 202 comprises multiple laser diodes, each of which produces uniform and spatially coherent light at the same wavelength. In yet another example, the power of the laser diode/s is in the range of 0.5kW to 50kW, but preferably approximately 2kW. Suitable laser diodes are made by Coherent Inc. of Santa Clara, California; Spectra-Physics of California; or by Cutting Edge Optronics, Inc. of St. Charles Missouri. A preferred laser diode is made by Cutting Edge Optronics, although another suitable laser diode is Spectra Physics' MONSOON^{®} multi-bar module (MBM), which provides 40-480 watts of continuous wave power per laser diode module.

The focusing optics 220 preferably comprise one or more collimators 206 to collimate radiation 204 from the continuous wave electromagnetic radiation source 202 into a substantially parallel beam 208. This collimated radiation 208 is then focused by at least one lens 210 into a line of radiation 222 at an upper surface 224 of the substrate 214.

Lens 210 is any suitable lens, or series of lenses, capable of focusing radiation into a line. In one example, lens 210 is a cylindrical lens. Alternatively, lens 210 may be one or more concave lenses, convex lenses, plane mirrors, concave mirrors, convex mirrors, refractive lenses, diffractive lenses, Fresnel lenses, gradient index lenses, or the like.

The stage 216 is any platform or chuck capable of securely holding the substrate 214 during translation, as explained below. In a preferred embodiment, the stage 216 includes a means for grasping the substrate, such as a frictional, gravitational, mechanical, or electrical system. Examples of suitable means for grasping include, mechanical clamps, electrostatic or vacuum chucks, or the like.

The apparatus 200 also comprises a translation mechanism 218 configured to translate the stage 216 and the fine of radiation 222 relative to one another. In one example, the translation mechanism 218 is coupled to the stage 216 to move the stage 216 relative to the continuous wave electromagnetic radiation source 202 and/or the focusing optics 220: In another example, the translation mechanism 218 is coupled to the continuous wave electromagnetic radiation source 202 and/or the focusing optics 220 to move the continuous wave electromagnetic radiation source 202 and/or the focusing optics 220 relative to the stage 216. In yet another embodiment, the translation mechanism 218 moves both the continuous wave electromagnetic radiation source 202 and/or the focusing optics 220, and the stage 216. Any suitable translation mechanism may be used, such as a conveyor system, rack and opinion system, or the like.

The translation mechanism 218 is preferably coupled to a controller 226 to control the scan speed at which the stage 216 and the line of radiation 222 move relative to one another. In addition, translation of the stage 216 and the line of radiation 222 relative to one another is preferably along a path perpendicular to the line of radiation 222 and parallel to the upper surface 224 of the substrate 214. In a preferred embodiment, the translation mechanism 218 moves at a constant speed. Preferably, this constant speed is approximately 2 cm/s for a 35 micron wide line. In another embodiment, the translation of the stage 216 and the line of radiation 222 relative to one another is not along a path perpendicular to the line of radiation 222.

The laser shown and described with respect to Figure 2 and other embodiments of lasers that may be used with the embodiments described herein are further described in commonly assigned U.S. Patent Application Serial No. 10/126,419, filed April 18, 2002, entitled "Thermal Flux Process by Scanning", published as US 2003/0196995.

After the substrate is annealed, the layer may be removed from the substrate. The layer comprising amorphous carbon or amorphous carbon and a dopant selected from a group consisting of nitrogen, boron, phosphorus, fluorine, or combinations thereof, the layer may be removed from the substrate by an oxygen ashing process. The oxygen.ashing process may be performed in a photoresist ashing chamber. Preferably, after the oxygen ashing process, the substrate is treated with a wet clean, such as a dilute HF clean or a SC1 + DI/O₃ clean, to remove residue from the ashing process.

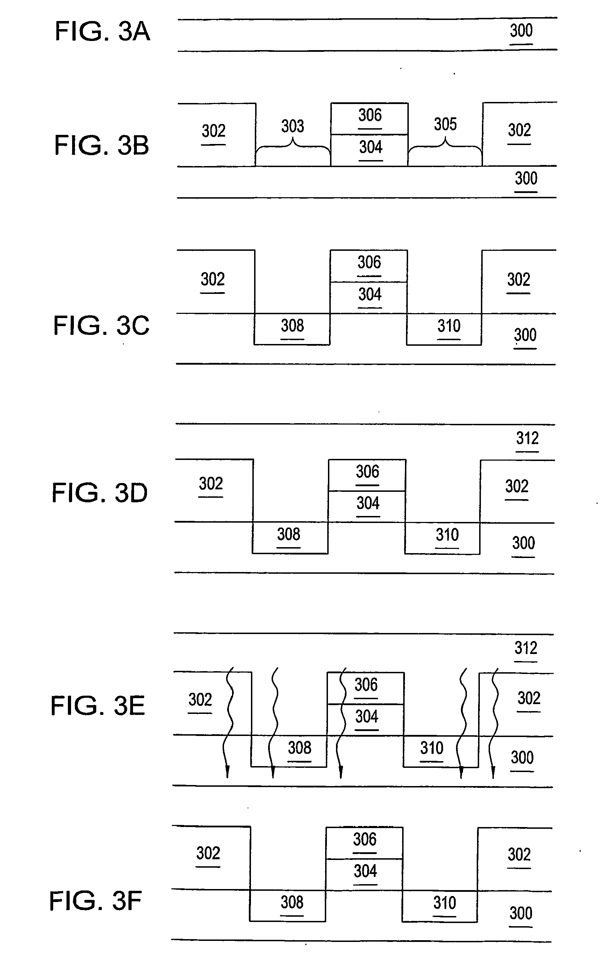

An exemplary substrate processing sequence according to an embodiment of the invention is described below with respect to Figures 3A-3F. A substrate 300 comprising silicon is provided, as shown Figure 3A. A field oxide layer 302, a gate dielectric 304, and a gate electrode 306 are deposited and patterned on the substrate 300 according to conventional methods to form source area 303 and drain area 305 in the substrate 300, as shown in Figure 3B. Dopant ions are then implanted into the substrate 300 to form source 308 and drain 310, as shown in Figure 3C. A layer 312 comprising amorphous carbon and optionally a dopant is then deposited according to an embodiment of the invention on the substrate 300, as shown in Figure 3D. The substrate 300 is then laser annealed according to an embodiment of the invention, as shown in Figure 3E. The layer 312 is then removed from the substrate, as shown in Figure 3F, such as by an oxygen ashing process.

While Figures 3A-3F show only one gate device on a substrate, it is recognized that the layers described herein will typically be formed on a substrate that includes a plurality of devices of different sizes, types, and materials and spaced at varying densities across the surface of the substrate. It is believed that the layers promote uniform heating across a surface of the substrate during annealing of the substrate in spite of varying device topography across the surface of a substrate. In particular, it is believed that the layers have high emissivities for electromagnetic radiation having a wavelength of between about 808 nm and about 810 nm that promote uniform heating across a surface of the substrate during a laser annealing process in which the substrate is exposed to electromagnetic radiation having a wavelength of between about 808 nm and about 810 nm.

### Examples

### Examples 1-9

A layer comprising amorphous carbon was deposited on 9 silicon substrates in a PECVD chamber under the following processing conditions: 550°C, 930 Pa (7 Torr), 700 watts RF power at a frequency of 13.56 MHz, 1200 sccm C₃H₆, 650 sccm He, and a spacing of 6.9 mm (270 mils) between the chamber showerhead and the substrate support. The layer was deposited in the absence of a chamber shadow ring in Examples 1-7. The layer was deposited with a chamber shadow ring present in Examples 8 and 9. The substrate was then laser annealed according to embodiments provided herein. The thickness of the deposited layer, deposition time, and the emissivity of the layer to electromagnetic radiation of 810 nm are shown in Table 1.

**TABLE 1**

| **Substrate** | **Approximate Thickness (Å)** | **Emissivity** | **Deposition Time (Sec)** |
|---|---|---|---|
| 1 | 936 | 0.89 | 63 |
| 2 | 800 | 0.84 | 54 |
| 3 | 900 | 0.89 | 61 |
| 4 | 1000 | 0.91 | 68 |
| 5 | 1100 | 0.93 | 74 |
| 6 | 1200 | 0.94 | 81 |
| 7 | 1300 | 0.92 | 88 |
| 8 | 900 | 0.87 | 34 |
| 9 | 1200 | 0.9 | 45 |

### Examples 10-17

A layer comprising amorphous carbon and nitrogen was deposited on 8 silicon substrates in a PECVD chamber under the following processing conditions: 400°C, 930 Pa (7 Torr), 1200 watts RF power at a frequency of 13.56 MHz, 350 sccm C₃H₆, 3400 sccm N₂, and a spacing of 6.9 mm (270 mils) between the chamber showerhead and the substrate support. The layer was deposited in the absence of a chamber shadow ring in Examples 10-15. The layer was deposited with a chamber shadow ring present in Examples 16 and 17. The substrate was then laser annealed according to embodiments provided herein. The thickness of the deposited layer, deposition time, and the emissivity of the layer to electromagnetic radiation of 810 nm are shown in Table 2.

| **Substrate** | **Approximate Thickness (Å)** | **Emissivity** | **Deposition Time (Sec)** |
|---|---|---|---|
| 10 | 800 | 0.91 | 17 |
| 11 | 900 | 0.95 | 19 |
| 12 | 1000 | 0.98 | 21 |
| 13 | 1100 | 0.99 | 24 |
| 14 | 1200 | 0.99 | 26 |
| 15 | 1300 | 0.97 | 28 |
| 16 | 850 | 0.94 | 17 |
| 17 | 1200 | 0.98 | 25 |

As shown in Tables 1 and 2, the layers comprising amorphous carbon and amorphous carbon and nitrogen and having a thickness between about 80 nm (800 Å) and about 150 nm (1500 Å) had emissivities of 0.84 or greater for electromagnetic radiation having a wavelength of between about 600 nm and about 1000 nm, such as between about 808 nm and about 810 nm, e. g., 810 nm. It was unexpectedly found that the layers comprising amorphous carbon and nitrogen had higher emissivities than layers of a comparable thickness that included amorphous carbon but not nitrogen. It is believed nitrogen increases the thermal conductivity of an amorphous carbon layer, as the band gap for an amorphous carbon layer deposited by PECVD is typically about 1.4 eV, while the band gap of an amorphous carbon layer comprising nitrogen is typically about 0.6 eV.

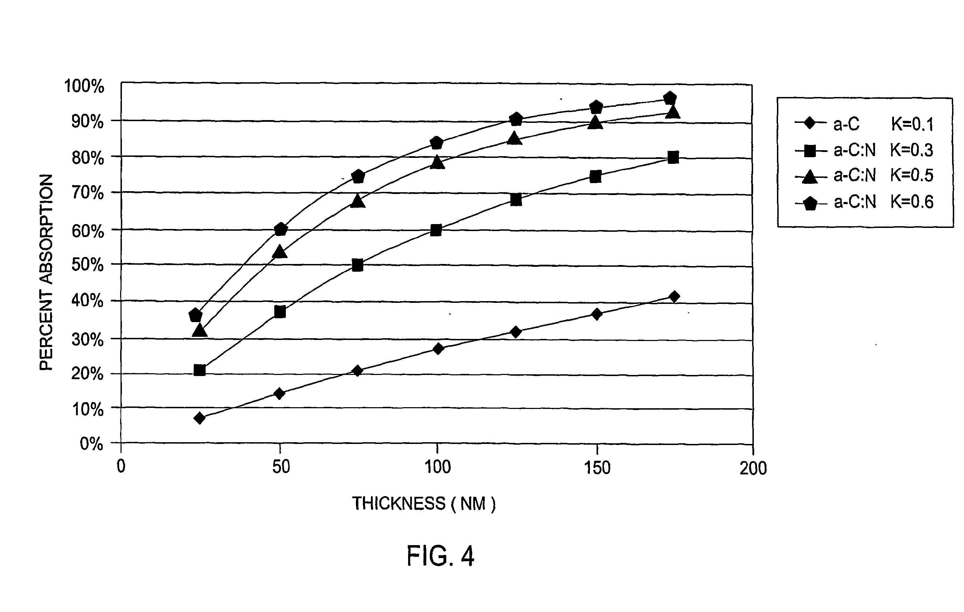

Figure 4 shows the % absorption of radiation having a wavelength of 810 nm of layers with different light absorption coefficients, k, and comprising amorphous carbon or amorphous carbon and nitrogen. Figure 4 shows that the layers comprising amorphous carbon and nitrogen absorbed a larger amount of the electromagnetic radiation having a wavelength of 810 nm than the layers of a comparable thickness that comprised carbon but not nitrogen. It is believed that adding nitrogen to an amorphous carbon layer increases the absorption of the layer of electromagnetic radiation having a wavelength of between about 600 nm and about 1000 nm, such as between about 808 nm and about 810 nm.

Other advantages of layers comprising amorphous carbon and nitrogen are recognized. For example, a layer comprising amorphous carbon and nitrogen can be deposited to a thickness, such as about 115 nm (1150 Å), at a lower temperature, such as at about 400°C, to achieve good absorption of electromagnetic radiation having a wavelength of between about 700 nm and about 1 mm, while a layer comprising amorphous carbon but not nitrogen typically must be deposited to a thickness, such as about 120 nm (1200 Å), at a higher temperature, such as at about 550°C, to achieve good absorption of electromagnetic radiation having a wavelength of between about 808 nm and about 810 nm. A lower deposition temperature is preferred, as it minimizes the substrate's exposure to temperatures that can cause undesirable recrystallization of the silicon in the substrate.

While the foregoing is directed to embodiments of the present invention, other and further embodiments of the invention may be devised without departing from the basic scope thereof, and the scope thereof is determined by the claims that follow.

## Claims

1. A method of processing a substrate (300), comprising:
depositing a layer (312) comprising amorphous carbon on the substrate (300),
the method **characterised by**
exposing the substrate to electromagnetic radiation having one or more wavelengths between 808 nm and 810 nm under conditions sufficient to heat the layer to a temperature of at least 300°C; and
wherein the step of depositing comprises depositing a layer comprising amorphous carbon and a dopant selected from the group consisting of nitrogen, boron, phosphorus, fluorine, and combinations thereof on the substrate.

2. The method of claim 1, wherein the dopant is nitrogen.

3. The method of claim 1, wherein the layer is deposited at a temperature between 250°C and 450°C.

4. The method of any of claims 1 to 3, wherein the exposing the substrate to electromagnetic radiation comprises laser annealing the substrate.

5. The method of claim 4, wherein the laser annealing comprises focusing continuous wave electromagnetic radiation into a line extending across a surface of the substrate.

6. The method of any of claims 1 to 3, wherein the electromagnetic radiation is provided by a lamp.

7. The method of any of claims 1 to 3, wherein the layer comprising amorphous carbon is deposited by plasma enhanced chemical vapor deposition.

8. The method of any of claims 1 to 3, further comprising removing the layer from the substrate after the exposing the substrate to electromagnetic radiation.

9. The method of any of claims 1 to 3, further comprising implanting dopant ions into the substrate before the depositing the layer comprising amorphous carbon.

10. The method of claim 9, wherein the substrate is exposed to the electromagnetic radiation for a period of time sufficient to activate the implanted dopant ions.

11. The method of any of claims 1 to 3, wherein the substrate (300) comprises silicon, and
the layer (312) has a thickness of between 20 nm and 2.5 µm and is deposited under conditions sufficient to provide the layer with an emissivity of 0.84 or greater for electromagnetic radiation having a wavelength of between 600 nm and 1000 nm; and
the step of exposing comprises laser annealing the substrate with said electromagnetic radiation.

12. The method of claim 11, wherein the layer has a thickness of between about 80 nm and about 150 nm, and the layer is deposited under conditions sufficient to provide the layer with an emissivity of 0.84 or greater for electromagnetic radiation having a wavelength of between 808 nm and 810 nm.

13. The method of claim 11, wherein the laser annealing comprises focusing continuous wave electromagnetic radiation into a line extending across a surface of the substrate.

14. The method of claim 11, further comprising implanting dopant ions into the substrate before the depositing the layer comprising amorphous carbon.

15. The method of claim 14, further comprising forming a source area (303) and a drain area (305) in the substrate before the implanting.

16. The method of claim 15, wherein the substrate is laser annealed for a period of time sufficient to activate the implanted dopant ions.

## Patentansprüche

1. Verfahren zur Bearbeitung eines Substrats (300), umfassend:
Abscheiden einer Schicht (312), welche amorphen Kohlenstoff umfasst, auf dem Substrat (300);
wobei das Verfahren **gekennzeichnet ist durch**
Aussetzen des Substrats elektromagnetischer Strahlung, welche eine oder mehrere Wellenlängen zwischen 808 nm und 810 nm aufweist, unter Bedingungen, die ausreichend sind, um die Schicht auf eine Temperatur von mindestens 300 ° C zu erwärmen; und
wobei der Schritt des Abscheidens Abscheiden einer Schicht auf dem Substrat umfasst, wobei die Schicht amorphen Kohlenstoff und ein Dotierungsmittel, ausgewählt aus der Gruppe, bestehend aus Stickstoff, Bor, Phosphor, Fluor und Kombinationen davon, umfasst.

2. Verfahren nach Anspruch 1, wobei das Dotierungsmittel Stickstoff ist.

3. Verfahren nach Anspruch 1, wobei die Schicht bei einer Temperatur zwischen 250 °C und 450 °C abgeschieden wird.

4. Verfahren nach einem der Ansprüche 1 bis 3, wobei das Aussetzen des Substrats elektromagnetischer Strahlung Laser-Wärmebehandlung des Substrats umfasst.

5. Verfahren nach Anspruch 4, wobei die Laser-Wärmebehandlung Fokussieren elektromagnetischer Strahlung kontinuierlicher Welle in eine Linie umfasst, welche sich über eine Oberfläche des Substrats erstreckt.

6. Verfahren nach einem der Ansprüche 1 bis 3, wobei die elektromagnetische Strahlung durch eine Lampe bereitgestellt wird.

7. Verfahren nach einem der Ansprüche 1 bis 3, wobei die Schicht, welche amorphen Kohlenstoff umfasst, durch plasmaunterstützte chemische Gasphasenabscheidung abgeschieden wird.

8. Verfahren nach einem der Ansprüche 1 bis 3, ferner umfassend Entfernen der Schicht von dem Substrat nach dem Aussetzen des Substrats elektromagnetischer Strahlung.

9. Verfahren nach einem der Ansprüche 1 bis 3, ferner umfassend Implantieren von Dotierungsmittel-Ionen in das Substrat vor dem Abscheiden der Schicht, welche amorphen Kohlenstoff umfasst.

10. Verfahren nach Anspruch 9, wobei das Substrat der elektromagnetischen Strahlung für einen Zeitraum ausgesetzt ist, welcher ausreichend ist, um die implantierten Dotierungsmittel-Ionen zu aktivieren.

11. Verfahren nach einem der Ansprüche 1 bis 3, wobei das Substrat (300) Silicium umfasst, und
die Schicht (312) eine Dicke von zwischen 20 nm und 2,5 µm aufweist und unter Bedingungen abgeschieden wird, die ausreichend sind, um die Schicht mit einer Emissivität von 0,84 oder höher für elektromagnetische Strahlung, welche eine Wellenlänge von zwischen 600 nm und 1000 nm aufweist, bereit zu stellen; und
der Schritt des Aussetzens Laser-Wärmebehandlung des Substrats mit der elektromagnetischen Strahlung umfasst.

12. Verfahren nach Anspruch 11, wobei die Schicht eine Dicke von zwischen ungefähr 80 nm und ungefähr 150 nm aufweist und die Schicht unter Bedingungen abgeschieden wird, die ausreichend sind, um die Schicht mit einer Emissivität von 0,84 oder höher für elektromagnetische Strahlung, welche eine Wellenlänge von zwischen 808 nm und 810 nm aufweist, bereit zu stellen.

13. Verfahren nach Anspruch 11, wobei die Laser-Wärmebehandlung Fokussieren elektromagnetischer Strahlung kontinuierlicher Welle in eine Linie umfasst, welche sich über eine Oberfläche des Substrats erstreckt.

14. Verfahren nach Anspruch 11, ferner umfassend Implantieren von Dotierungsmittel-Ionen in das Substrat vor dem Abscheiden der Schicht, welche amorphen Kohlenstoff umfasst.

15. Verfahren nach Anspruch 14, ferner umfassend Bilden eines Source-Bereichs (303) und eines Drain-Bereichs (305) in dem Substrat vor dem Implantieren.

16. Verfahren nach Anspruch 15, wobei das Substrat Laserwärmebehandelt wird für einen Zeitraum, welcher ausreichend ist, um die implantierten Dotierungsmittel-Ionen zu aktivieren.

## Revendications

1. Procédé de traitement d'un substrat (300), comprenant :
le dépôt d'une couche (312) comprenant du carbone amorphe sur le substrat (300),
le procédé **caractérisé par**
l'exposition du substrat à un rayonnement électromagnétique ayant une ou plusieurs longueur(s) d'onde entre 808 nm et 810 nm dans des conditions suffisantes pour chauffer la couche à une température d'au moins 300°C ; et
dans lequel l'étape de dépôt comprend le fait de déposer une couche comprenant du carbone amorphe et un dopant choisi dans le groupe consistant en un atome d'azote, un atome de bore, un atome de phosphore, un atome de fluor, et des combinaisons de ceux-ci sur le substrat.

2. Procédé de la revendication 1, dans lequel le dopant est un atome d'azote.

3. Procédé de la revendication 1, dans lequel la couche est déposée à une température comprise entre 250°C et 450°C.

4. Procédé de l'une des revendications 1 à 3, dans lequel l'exposition du substrat à un rayonnement électromagnétique comprend un recuit par laser du substrat.

5. Procédé de la revendication 4, dans lequel le recuit par laser comprend la focalisation d'un rayonnement électromagnétique à onde continue en une ligne s'étendant à travers une surface du substrat.

6. Procédé de l'une des revendications 1 à 3, dans lequel le rayonnement électromagnétique est fourni par une lampe.

7. Procédé de l'une des revendications 1 à 3, dans lequel la couche comprenant du carbone amorphe est déposée par dépôt chimique en phase vapeur activé par plasma.

8. Procédé de l'une des revendications 1 à 3, comprenant en outre l'élimination de la couche à partir du substrat après l'exposition du substrat à un rayonnement électromagnétique.

9. Procédé de l'une des revendications 1 à 3, comprenant en outre l'implantation d'ions dopants dans le substrat avant le dépôt de la couche comprenant du carbone amorphe.

10. Procédé de la revendication 9, dans lequel le substrat est exposé au rayonnement électromagnétique pendant une duré suffisante pour activer les ions dopants implantés.

11. Procédé de l'une des revendications 1 à 3, dans lequel le substrat (300) comprend du silicium, et
la couche (312) a une épaisseur comprise entre 20 nm et 2,5 µm et est déposée dans des conditions suffisantes pour fournir à la couche une émissivité supérieure ou égale à 0,84 pour un rayonnement électromagnétique ayant une longueur d'onde comprise entre 600 nm et 1000 nm ; et
l'étape d'exposition comprend le recuit par laser du substrat avec ledit rayonnement électromagnétique.

12. Procédé de la revendication 11, dans lequel la couche a une épaisseur comprise entre environ 80 nm et environ 150 nm, et la couche est déposée dans des conditions suffisantes pour fournir la couche avec une émissivité supérieure ou égale à 0,84 pour un rayonnement électromagnétique ayant une longueur d'onde comprise entre 808 nm et 810 nm.

13. Procédé de la revendication 11, dans lequel le recuit par laser comprend la focalisation de rayonnement électromagnétique à onde continue en une ligne s'étendant à travers une surface du substrat.

14. Procédé de la revendication 11, comprenant en outre l'implantation d'ions dopants dans le substrat avant le dépôt de la couche comprenant du carbone amorphe.

15. Procédé de la revendication 14, comprenant en outre la formation d'une zone de source (303) et d'une zone de drain (305) dans le substrat avant l'implantation.

16. Procédé de la revendication 15, dans lequel le substrat est recuit par laser pendant une durée suffisante pour activer les ions dopants implantés.
